# EUROPEAN PATENT APPLICATION

(11) **EP 1 536 038 A1**
(43) Date of publication of application: **01.06.2005**
(21) Application number: 03738504.4
(22) Date of filing: 23.06.2003
(51) Int. Cl.: C23C 24/00, C23C 26/00

(54) **METHOD FOR FORMING FINE STRUCTURE OF A GROUP OF METAL FINE PARTICLES**

(30) Priority: 05.07.2002 JP 2002197212
(71) Applicant: Japan Science and Technology Agency, Kawaguchi-shi, Saitama 332-0012 (JP)
(72) Inventor: YAMADA, Sunao, Kasuya-gun, Fukuoka 811-0113 (JP); NIIDOME, Yasuro, Fukuoka-shi, Fukuoka 812-0053 (JP)
(74) Representative: McCluskie, Gail Wilson
(86) International application number: PCT/JP2003/007929
(87) International publication number: WO 2004/005578

(57) **Abstract**

A method for forming a fine structure of metal fine particles includes a step [Fig.1(a)] of substituting a part of metal fine particles stabilized by a dispersion stabilizer desorbed when irradiated with an electromagnetic wave of high energy and/or high energy density and a dispersing agent from the surface of the metal fine particles when irradiated with an electromagnetic wave of a lower energy and/or a lower energy density and/or a compound having no bonding ability to the metal fine particles so as to prepare a colloidal solution of the metal fine particles, irradiating the colloidal solution with the electromagnetic wave of high energy and/or high energy density, and thereby improve the photosensitivity of the metal fine particles dispersed solution, and a step [Fig.1(b)] of irradiating the metal fine particles dispersed solution having the improved photosensitivity with an electromagnetic wave of a lower energy and/or a lower energy density, and fixing the metal fine particles to a desired fine structure corresponding to the irradiation with the electromagnetic wave of the lower energy and/or the lower energy density on the surface of a substrate.

## Description

### FIELD OF THE INVENTION

The present invention relates to a method to form activated and photosensitized metal fine particles dispersion comprising, irradiating electromagnetic wave of high energy and/or electromagnetic wave of high energy density to a dispersion of metal fine particles and fixing a fine metal from said metal fine particles which is flocculated by irradiation of electromagnetic wave of lower energy and/or electromagnetic wave of lower energy density than said electromagnetic wave on surface of a substrate, and relates to a method to flocculate and fix said metal particles by desired fine structure on surface of a substrate comprising, a process to flocculate metal fine particles by irradiating said electromagnetic wave of low energy and/or electromagnetic wave of low energy density to said activated and photosensitized metal fine particles dispersion.

### BACK GROUND OF THE ART

Fine particles of a noble metal, for example, fine particles of gold is paid attention to as a base material to form various functional materials. In particular, a substrate consisting of said metal fine particles or a substrate which forms said metal fine particles on the surface is utilized in broad fields, because said substrates have an effect which said metal fine particles peculiarly own and a function to bond a compound which has an affinity group to said metal by self-organization, by non-covalent bond or by covalent bond.

In said circumstance, the inventors of the present invention already proposed methods to fix above metal particles on various substrates composed of transparent or not transparent material to the light having longer wavelength than UV ray.

For example, the inventors of the present invention have already developed and proposed a technique to fix metal particles from a dispersion of metal fine particles by dipping a substrate into organic solvent dispersion of metal fine particles and by irradiating a laser beam of wavelength from ultra violet to near-infra red region (Japanese Patent Laid-Open Publications 2001-149774, 2002-88487).

However, in these methods, since so called the light belonging to the region from UV to near-infra red is used, fixing of metal particles is restricted to the surface area where said light reaches, and it is impossible to fix metal fine particles to the part where said light can not permeate, for example, the back surface of the parts, namely opposite side to the light irradiation side, especially, to the inner surface of a cylindrical parts (with hollow part). Thereby the inventors of the present invention also proposed the fixing method of metal fine particles comprising, irradiating a radiation which permeate a parts being opaque against the light belonging to the region from UV region to near-infra red, for example, electromagnetic wave of 0.001nm-10nm wavelength, to the metal fine particles in the dispersion of said metal fine particles so as to fix the metal fine particles on the opaque surface of the parts of the side where at least said radiation permeates (Japanese Patent Laid-Open Publication 2002-144378 filed on May 20, 2002).

Furthermore, the inventors of the present invention investigated the composition of dispersing agent of metal fine particles, dispersing stability of said fine particles and photo-reactivity concerning photo-reactivity of dispersion of metal fine particles in cases when 1-dodecanethiol is used alone as a surface decorative compound of said metal fine particles and when from 5 to 10% of said 1-dodecanethiol is substituted by diols [SH(C₆H₁₂)SH, SH(C₁₀H₁₂₀)SH] and reported that the dispersion of metal fine particles with high photo-reactivity can be obtained when 10% is substituted by SH(C₆H₁₂) (abstract of 38th Chemical Society Kyushu forum; number 1.46: Fixing of surface decorative gold nano particles by pulse laser irradiation, Effect of dithiol decorative (July 19, 2001) Document 1, Photochemical forum of 2001, 50^{th} academy of Japan Chemical Analysis Society, presented at 20^{th} Solid-Surface chemical forum) .

Still further, the inventors of the present invention indicated the application to a measuring technique which utilize the improvement of functionality as a resonance Raman sensor by the metal fine particles. And since said metal bonds with end thiol group, amino group, silyl group or cyano group of adequate chemical structure by non-covalent bond or by covalent bond, it is known that said metal has a function to self-organize the compound having said groups.

The characteristic of the self-organizable compound is that having thiol group, amino group, silyl group or cyano group which bonds with said metal at the end, and a molecule has a chemical structure in which intermolecular force sequenced by structure close to monomolecular film, for example, lipophilic chemical structure such as long chain alkyl structure. Further, by possessing a functional group which recognize other adequate chemical structure besides chemical structure, for example, a group of antigen-antibody relationship, it can be used as a sensor utilizing said relationship. And, by making said sequence to a structure which can intense energy, it is possible to form a fine structure of said metal fine particles which generate the reinforcing function of the signal comes from said compound.

For the accomplishment of above characteristics, it is very important to construct a method which can achieve fixing of fine structure of said metal fine particles on adequate substrate surface so as to utilize effectively said function.

In the method proposed by the inventors of the present invention which aggregate and fix metal fine particle from colloidal solution of metal fine particles on the surface of substrate, irradiation of electron wave of respectively high energy is necessary, and such irradiation of such high energy, there is a problem to hurt the substrate to injure a photo mask in a case when the irradiation is carried out through the photo mask. Therefore, the establishment of a technique for fixing method of metal fine particles on surface of a substrate which the use of broad industrial fields, in which said problems are dissolved.

The subject of the present invention is to provide a method to fix metal particles on novel surface of substrate from which an inconvenience such as injury of the substrate of the photo mask is removed, in particular, to provide a method to fix metal particles on by fine structure on surface of a substrate by comparatively simple method which uses a photo mask.

During the investigation to accomplish the method to dissolve said subject, the inventors of the present invention paid attention to the fact that the photo reactivity is improved by replacing 10% of n-decylthiol which is a dispersion stabilizer used at the preparation of colloidal dispersion of metal fine particles, which were reported by the inventors of the present invention, with a compound e.g. 1,6-hexanedithiol which can cause flocculation and fixing of metal fine particles by relatively small energy, and investigated whether it is possible to construct colloidal dispersion of metal fine particles which can cause flocculation and fixing of metal fine particles by relatively small energy.

In said investigation, the inventors of the present invention have found that flocculation and fixing of metal fine particles can be carried out by relatively small energy by following process, that is, irradiating relatively high power and/or high density electromagnetic wave to colloidal dispersion of metal fine particles prepared by dispersing metal fine particles, which are coat treated by a dispersion stabilizer, into organic solvent to which a compound being possible to cause flocculation and fixing of metal fine particles by relatively small energy is added, and can accomplish the method to fix metal fine particles on the surface of substrate whose problem is dissolved by fine structure.

### DISCLOSURE OF THE INVENTION

The present invention is (1) a method to fix metal fine particles on surface of a substrate by desired fine structure corresponding to irradiation of low power and/or low density electromagnetic wave comprising; releasing a part of a dispersion stabilizer locating on the surface of metal fine particles by irradiating high energy electromagnetic wave and/or high energy density electromagnetic wave to a colloidal dispersion of metal fine particles prepared from a solution containing a compound which does not have bonding ability to the dispersing agent and/or metal fine particles with the dispersing agent and/or compound by substituting a part of the dispersing stabilizer, wherein, said dispersing agent is released by irradiation of lower energy electromagnetic wave and/or lower energy density electromagnetic wave from the surface of metal fine particles stabilized by the dispersion stabilizer, which can be released by irradiation of the high energy electromagnetic wave and/or high energy density electromagnetic wave, and
a process to irradiate said high energy electromagnetic wave and/or high energy density electromagnetic wave which generate metal fine particles which are activated so as to cause flocculation of 2-100 times larger particle size to the metal fine particles stabilized by said dispersion stabilizer, and irradiating lower energy electromagnetic wave and/or lower energy density electromagnetic wave to said metal fine particles dispersion whose photo sensitivity is improved by activation.

Desirably, the present invention (2) is the method to fix metal fine particles on surface of the substrate (1) by desired fine structure, wherein the dispersion stabilizer is a compound possessing thiol group, amino group, silyl group or cyano group as a substitution group having affinity with metal fine particles, for example, a compound bonded with alkyl group of normal chain of carbon number 10 or more, more desirably, the present invention (3) is the method to fix metal fine particles on surface of the substrate of (2) by desired fine structure, wherein the dispersion stabilizer is an agent used at the preparation of metal colloidal solution by chemical reduction of a metal compound.

Further desirably, the present invention (4) is the method to fix metal fine particles on surface of a substrate of (1), (2) or (3) by desired fine structure, wherein the compound which does not have bonding ability to a dispersing agent released from the surface of the metal fine particles by irradiation of electromagnetic wave of lower energy than a dispersion stabilizer of metal fine particles and/or metal fine particles is a compound whose solvent affinity part is small and/or a compound which causes the release by absorbing said electromagnetic wave.

Furthermore desirably, the present invention (5) is the method to fix metal fine particles on surface of a substrate of (1), (2), (3) or (4), wherein the particle size of the metal fine particles is from 1nm to 100nm, still further desirably, the present invention (6) is the method to fix metal fine particles on surface of a substrate of (5), wherein the particle size of the metal fine particles is from 2nm to 30nm.

Yet further desirably, the present invention (7) is the method to fix metal fine particles on surface of a substrate of (1), (2), (3), (4), (5) or (6), wherein the dispersing solvent is at least one selected from the group consisting of alicyclic hydrocarbon and aromatic hydrocarbon.

### BRIEF ILLUSTRATION OF THE DRAWINGS

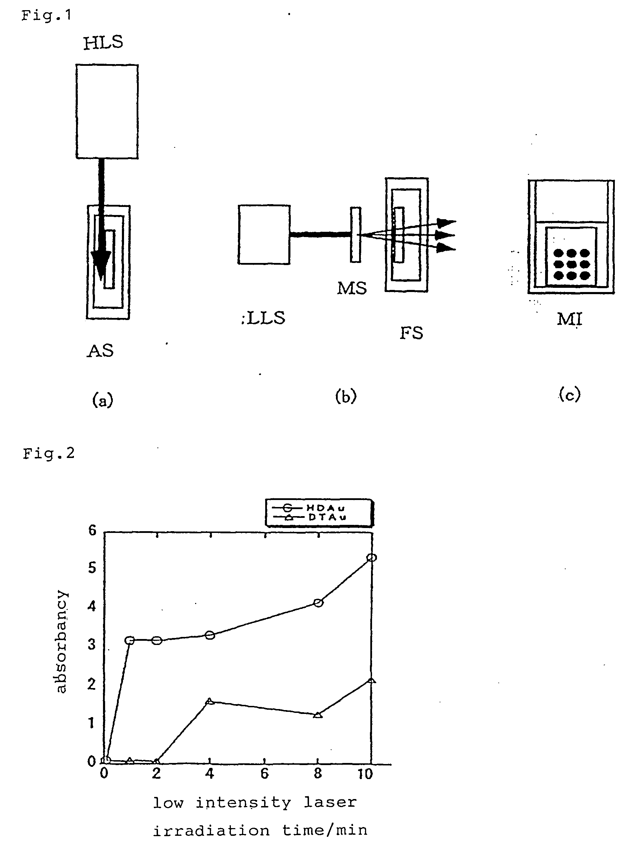

Fig.1 is a drawing to illustrate a theory of fixing of metal nano particles by 2 steps irradiation of the present invention. (c) metal nano particles fixing pattern (MI) is formed. (a) is the activation process (AS) of particles in solvent by irradiation of high intensity pulse light (pre second harmonic generation (SHG) laser (532nm), 10Hz, 33mj/pulse) from high intensity light source HLS, and (b) is the fixing process (FS) by irradiating patterned light (pre 7mJ/pulse) through a mask MS using low intensity light source LLS, then (c) metal nano particles fixing pattern (MI) which is micro alloyed is formed.

Fig.2 shows the difference of fixing amount between DTAu (Δ, colloidal solution 1) and HDAu (○, colloidal solution 2). It become clear that by same irradiation energy, DTAu (○) can fix larger amount gold. This is obviously understood from the relationship between low intensity laser irradiation time (minutes) of dithiol substituted gold nano particles of colloidal solution 2 and fixing amount of gold nano particles.

Fig.3 shoes the microscopic picture observing a pattern of fixed gold nano particles by SEM image (33mJ/pulse) of fixed gold nano particles.

Fig.4 indicates the characteristic of gold nano particles pattern which is fixed by 2 steps irradiation (33mJ/pulse, 7mJ/pulse) of the present invention.

### DESCRIPTION OF THE PREFERRED EMBODYMENT

The present invention will be illustrated more in detail.

### A. Preparation of metal fine particles;

Solution of metal fine particles used in the process to fix metal fine particles of the present invention is the solution of metal fine particles of particle size from 1nm to 100nm, desirably from 2nm to 30nm, and is the colloidal solution which disperses particles whose surface is protected by a dispersion stabilizer such as dodecanethiol so as to slightly released by irradiation of electromagnetic wave. Photo-reactivity of particles having large particle size is improved relating with particle size, however, since said particles have a tendency to flocculate easily and lower dispersion stability, said particles are not suited for long term preservation. On the contrary, particles having relatively small particle size smaller than 2nm is superior at dispersion stability, however, have a tendency not to absorb easily light of relatively lower energy and not to be photo-reactivated easily.

The basic concept of the present invention is, to maintain dispersion stability till the actual use, and make it possible to provide effectively activation by irradiation of light, by replacing a part of said dispersion stabilizer with a compound which does not have dispersing ability releasing from the surface of said metal fine particles by irradiation of small and low energy electromagnetic wave and/or bonding ability to metal fine particles. Said improvement of activation is to prepare and use colloidal solution of metal fine particles which can form dispersion of metal fine particles having 2nm-30nm particle size which is 2-100 times larger particle size than that of stabilized dispersed metal fine particles.

As a metal to compose of said colloidal solution of metal fine particles, a metal having plasmon absorbing band e.g. Ag, Au, Pt or Cu. In the case of gold fine particles, particles having 10nm or less can be prepared easily according to the method of Leff (J. Phys. Chem., 99, 7036 (1995)). In this method, since dodecanethiol which disperse and stabilize formed metal fine particles is added to the prepared series, the metal fine particles are protected by the dispersion stabilizer and can be dispersed in organic solvent such as toluene or cyclohexane, especially, can be dispersed stably in a low polar solvent.
In the case of gold fine particles prepared by above mentioned method, the gold fine particles are dispersed into dispersion in which dodecanethiol, which is a dispersion stabilizer, and a compound which does not have dispersing ability releasing from the surface of said metal fine particles by irradiation of small and low energy electromagnetic wave and/or bonding ability so as to make possible to substitute a part of dodecanethiol, which is adsorbed to the surface of fine particles after prepared with said compound. In a case when the compound to be substituted is 1.6-hexanedithiol or cyclohexanethiol, the substitution of only 5% of dodecanethiol, the dispersing stability is not spoiled. As the other compounds of said compound, it is effective to substitute with a compound which absorb light such as various pigments which improve the photo-reactivity of metal nano particles, especially, with a pigment which releases easily from the surface of particles by the photo reactivity of pigment itself. However, even if a compound which does not absorb the irradiated light (electromagnetic wave) e.g. above mentioned dithiol compound or cyclohexanethiol, make dispersion stability in solution of metal fine particles remarkably deteriorate, for example, the fixing effect by by lower energy electromagnetic and/or lower energy density electromagnetic wave can be remarkably improved by substitution of approximately 10%.

### B. Activation;

A part of dispersion stabilizer of metal fine particles surface is released by irradiating electromagnetic wave of relatively strong energy to the dispersion of said metal fine particles and improve the flocculation ability of metal fine particles in dispersion. For example, in the case to irradiate second harmonic generation (SHG) laser of Nd-YAG laser, it is desirable to carry out the irradiation of 10 seconds to 3 minutes by irradiation intensity of 20mJ/pulse- 60mJ/pulse. Excess intensity and excess time of irradiation cause flocculation·sedimentation of solution, while, activation can not be carried out by too low intensity of irradiation. Further, the light (electromagnetic) irradiation for activation is desirable to be carried out from different direction to the irradiating direction for fixing. By activating particles location closely to a substrate, flocculation · sedimentation of particles in solution can be prevented and the fixing effect to the substrate can be remarkably improved.

### C. Controlling of particle size;

Particles to which high intense electromagnetic wave is irradiated flocculate by releasing of a protecting agent, and are fused by absorbed energy of electromagnetic wave so that the particle size grows up. It is possible to control the particle size of particles to be fixed by changing wavelength or energy of the electromagnetic wave to be irradiated, and by changing kinds of compound to be substituted with a dispersing stabilizer locating on the surface of fine particles and replacing ratio.

### D. Fixation;

Metal fine particles which are activated by irradiation of said relatively high intense light can be easily flocculated and fixed by irradiation of relatively low intense electromagnetic wave. For example, in the case of SHG laser of Nd-YAG laser (532nm), it is possible to fix particles on surface of a substrate by irradiation of 6mJ/pulse or less, however, in the case that an activation process by relatively high intense light is not carried out, fixation does not progressed at all. As the light for fixation, not only relatively low intense pulse light source but also CW laser or U.V light ca be used.

### E. Patterning;

The part to which particles are fixed can be patterned by irradiating the light for fixing through chrome vapor deposition mask. Since by using coherent CW laser a refraction pattern generator can be used for patterning of particles fixation, more convenient patterning of particles fixation is possible. It is possible to use high intense pulse laser which is used for activation of particles for patterning of fixation as it is, however, since it damages to the mask, an expensive device which scans high intense laser beam spatially is needed.

### F. Flocculation state control;

When high intense pulse laser is irradiated to the particles solution, particles are fused by absorbed photon energy and fixed by forming spherical isolated particles. When low intense electromagnetic wave is used for particle fixation, it is hard to cause the fusing of particles. Therefore, it is possible to fix particle flocculated body on a substrate by maintaining the flocculation structure in the solution. By controlling the flocculation structure of particles, it becomes possible to design the characteristics as a particle group. For example, a particles flocculation structure which is suited for a sensor for surface enhanced Raman or surface enhanced infrared absorption can be realized.

### Example

The present invention will be illustrated specifically, however, not intending to limit the scope of the present invention.

### Reference Example 1

### Acceleration of fixing of gold nano particles

Process 1; For the preparation of gold fine particles, the method of Leff et al document was used. Chloride aureate was transferred to organic phase (toluene) by tetraoctylammoniumbromide, and surface decorated gold nano particles (DTAu, 22 ± 0.5nm) with DT by reducing with hydrogenated sodium boride were prepared. Obtained particles were dispersed into cyclohexane (0.43mg/mL) (colloidal solution 1) and used for an experiment of laser irradiation.
Process 2; DTAu particles prepared by said process 1 was dispersed into cyclohexane solution containing 0.9mM of DT and 0.1mM of hexanediol, and gold nano particles (HDAu, 27±0.5nm) wherein a part of DT locating on the surface of said DTAu particles is substituted by HD was prepared. HDAu in thiol solution was washed, then dispersed in cyclohexane (0.32mg/mL) and was used for an experiment of laser irradiation (colloidal solution 2).

Absorption spectrum of two kinds of colloidal solution (1 and 2) were measured and by adding cyclohexane slowly and prepared to adjust the absorbance of absorption peak at 532nm becomes 0.5.

### Preparation of a substrate for metal fine particles fixation.

A cover glass (Matsunami, 18 × 18mm, 0.12-0.17mm) was soaked into boiling mix solution of aqueous ammonia (28%)/aqueous hydrogen peroxide (30%) (1:1) for several minutes so as the surface to hydrophilizate.

### Fixation of metal fine particles;

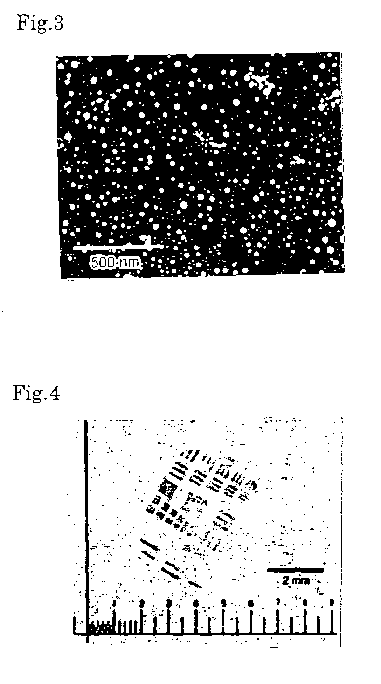

Soaked into DTAu (colloidal solution 1) or HDAu (colloidal solution 2) contained in a glass cell (20 × 10 × 5mm) and SHG laser (532nm, 10Hz, 33mJ/pulse)of Nd-YAG laser (product of Continum Co., Ltd., Surelite I) was irradiated [Fig.1; (a) shows the activation process (AS) of particles in solution by high intense pulse light (HLS) irradiation from high intense light source HLS (in this case, same laser was used and intensity was changed), (b) shows the fixation process (FS) by low intense pulse light which is patterned through mask (MS) from low intense light source LLS, and (c) shows micro alloyed metal nano particles fixed pattern (MI)]. Ultraviolet and visible ray absorption spectrum of gold fixed on a substrate was measured by a multi channel spectrometer (Ocean Optics, S1024DW). Then the cover glass was soaked into aqua regia so as to dissolve the gold fixed on the surface, and quantitated the fixed gold using ICP. MS (Yokokawa Analytical Systems PMS2000). Further, the surface of the substrate on which gold fine particles are fixed is observed by SEM (Hitachi S-5000). Difference of the amount of fixation between DTAu (colloidal solution 1) and HDAu (colloidal solution 2) are shown in Fig.2. By the observation of Fig.2, it becomes clear that HDAu can fix more quantity of gold than DTAu, by same irradiation energy. SEM observation of the fixed DAu particles is shown in Fig.3. In comparison with DTAu, it is obvious that particles of larger particle size are fixed, and it is understood that the diol substitution effects to the size of fixed particles (Presented at 2001 Photo Chemical Forum, 50^{th} Convention of Japan Analytical Chemistry Society, 20^{th} Solid·Surface Photochemical Forum). In this case, the damage of a mask is not recognized by observation by naked eyes or by a microscope.

### Example 1

In this Example, above mentioned colloidal solution 2 was used, and photo fixing property of gold fine particles fixation when the activation process is used is used.

Irradiation by 33mJ/pulse was carried out on cyclohexane solution of HDAu (colloidal solution 2) (absorbancy 0.5) for 5 minutes and activated the solution [process (a) of Fig.1]. A chrome vapor deposition test pattern was used as a mask (MS), irradiated by 7mJ/pulse for 5 minutes and a fixation pattern of gold nano particles was prepared [process (b) of Fig.1]. Since the chrome vapor deposition mask (MS) is damaged violently, it can not be used directly for the preparation of a fixation pattern. The pattern of gold nano particles fixed by irradiation of above mentioned 7mJ/pulse is shown in Fig.4 [corresponding to process (c) of Fig.1]. It was possible to fix gold particles by patterning on the surface of substrate without damaging the mask. It was understood that resolvability of several ten micro meter can be easily obtained by a method to provide a chrome vapor deposition mask to the outer surface of the cell.

As mentioned above, it is obvious that the fine structure composed of metal fine particles flocculation can be formed without deteriorating the material of substrate by electromagnetic wave in short time by flocculating and fixing the metal fine particles from the dispersion of metal fine particles by at least two processes of electromagnetic wave irradiation.

### POSSIBILITY FOR THE INDUSTRIAL APPLICABILITY

In the present invention, a part of dispersion stabilizer of metal fine particles substituted by a compound which does not have similar dispersing ability to the dispersion agent released from the surface of said metal fine particles by irradiation of lower energy electromagnetic wave than said dispersion agent and previously photo activate metal fine particles in solution, and the irradiation energy and irradiation time necessary in a continuation fixing process can be remarkably reduced. Consequently, the technique of pattern fixation of metal fine particles (group) is improved remarkably from the conventional technique, and it become possible to be used as the production technique for a micro alloy sensor.

## Claims

1. A method to fix metal fine particles on surface of a substrate by desired fine structure corresponding to irradiation of low power and/or low density electromagnetic wave comprising;
releasing a part of a dispersion stabilizer locating on the surface of metal fine particles by irradiating high energy electromagnetic wave and/or high energy density electromagnetic wave to a colloidal dispersion of metal fine particles prepared from a solution containing a compound which does not have bonding ability to the dispersing agent and/or metal fine particles with the dispersing agent and/or compound by substituting a part of the dispersing stabilizer, wherein, said dispersing agent is released by irradiation of lower energy electromagnetic wave and/or lower energy density electromagnetic wave from the surface of metal fine particles stabilized by the dispersion stabilizer, which can be released by irradiation of the high energy electromagnetic wave and/or high energy density electromagnetic wave, and
a process to irradiate said high energy electromagnetic wave and/or high energy density electromagnetic wave which generate metal fine particles which are activated so as to cause flocculation of 2-100 times larger particle size to the metal fine particles stabilized by said dispersion stabilizer, and irradiating lower energy electromagnetic wave and/or lower energy density electromagnetic wave to said metal fine particles dispersion whose photo sensitivity is improved by activation.

2. The method to fix metal fine particles on surface of the substrate by desired fine structure of claim 1, wherein the compound which does not have bonding ability to a dispersing agent released from the surface of the metal fine particles by irradiation of electromagnetic wave of lower energy than a dispersion stabilizer of metal fine particles and/or metal fine particles is a compound whose solvent affinity part is small and/or a compound which causes the release by absorbing said electromagnetic wave.

3. The method to fix metal fine particles on surface of the substrate by desired fine structure of claim 1, wherein the dispersion stabilizer is a compound possessing thiol group, amino group, silyl group or cyano group which has high affinity with metal fine particles.

4. The method to fix metal fine particles on surface of the substrate by desired fine structure of claim 1, wherein the dispersion stabilizer is a compound possessing thiol group, amino group, silyl group or cyano group which has high affinity with metal fine particles, and the compound which does not have bonding ability to a dispersing agent released from the surface of the metal fine particles by irradiation of electromagnetic wave of lower energy than a dispersion stabilizer of metal fine particles and/or metal fine particles is a compound whose solvent affinity part is small and/or a compound which causes the release by absorbing said electromagnetic wave.

5. The method to fix metal fine particles on surface of the substrate by desired fine structure of claim 3, combining same kinds of electromagnetic waves having different energy intensity and/or different energy density and carrying out at least two steps of irradiation process of electromagnetic wave comprising, at least one step of irradiation process by high energy intensity electromagnetic wave and/or high energy density electromagnetic wave and at least one step of irradiation process by low energy intensity electromagnetic wave and/or low energy density electromagnetic wave.

6. The method to fix metal fine particles on surface of the substrate by desired fine structure of claim 4, combining same kinds of electromagnetic waves having different energy intensity and/or different energy density and carrying out at least two steps of irradiation process of electromagnetic wave comprising, at least one step of irradiation process by high energy intensity electromagnetic wave and/or high energy density electromagnetic wave and at least one step of irradiation process by low energy intensity electromagnetic wave and/or low energy density electromagnetic wave.

7. The method to fix metal fine particles on surface of the substrate by desired fine structure of claim 6, wherein the particle size of the metal fine particles stabilized by a dispersion stabilizer is from 1nm to 100nm.

8. The method to fix metal fine particles on surface of the substrate by desired fine structure of claim 1, wherein the particle size of the metal fine particles stabilized by a dispersion stabilizer is from 1nm to 100nm.

9. The method to fix metal fine particles on surface of the substrate by desired fine structure of claim 3, wherein the particle size of the metal fine particles stabilized by a dispersion stabilizer is from 1nm to 100nm.

10. The method to fix metal fine particles on surface of the substrate by desired fine structure of claim 4, wherein the particle size of the metal fine particles stabilized by a dispersion stabilizer is from 1nm to 100nm.

11. The method to fix metal fine particles on surface of the substrate by desired fine structure of claim 1, wherein the dispersing solvent is at least one selected from the group consisting of alicyclic hydrocarbon and aromatic hydrocarbon.

12. The method to fix metal fine particles on surface of the substrate by desired fine structure of claim 3, wherein the dispersing solvent is at least one selected from the group consisting of alicyclic hydrocarbon and aromatic hydrocarbon.

13. The method to fix metal fine particles on surface of the substrate by desired fine structure of claim 4, wherein the dispersing solvent is at least one selected from the group consisting of alicyclic hydrocarbon and aromatic hydrocarbon.

14. The method to fix metal fine particles on surface of the substrate by desired fine structure of claim 5, wherein the dispersing solvent is at least one selected from the group consisting of alicyclic hydrocarbon and aromatic hydrocarbon.

15. The method to fix metal fine particles on surface of the substrate by desired fine structure of claim 6, wherein the dispersing solvent is at least one selected from the group consisting of alicyclic hydrocarbon and aromatic hydrocarbon.

16. The method to fix metal fine particles on surface of the substrate by desired fine structure of claim 7, wherein the dispersing solvent is at least one selected from the group consisting of alicyclic hydrocarbon and aromatic hydrocarbon.
